# EUROPEAN PATENT SPECIFICATION

(11) **EP 2 778 620 B1**
(45) Date of publication and mention of the grant of the patent: **17.10.2018**
(21) Application number: 14159340.0
(22) Date of filing: 13.03.2014
(51) Int. Cl.: G01D 4/00

(54) **System and computer-readable medium for storing utility usage data based on temperature**
System und computerlesbares Medium zur Speicherung von Verbrauchsdaten auf Grundlage der Temperatur
Système et support lisible par ordinateur pour stocker des données de consommation sur la base de la température

(30) Priority: 15.03.2013 US 201313841697
(43) Date of publication of application: 17.09.2014
(73) Proprietor: Aclara Meters LLC, St. Louis, MO 63146 (US)
(72) Inventor: Lavoie, Gregory Paul, Somersworth, NH 03878 (US); Lafond, Guy, Somersworth, NH 03878 (US); Subirana, Jason, Somersworth, NH 03878 (US)
(74) Representative: Lecomte & Partners

(56) References cited:
- DE-A1-102004 055 088
- US-A1- 2010 153 035
- US-A1- 2010 211 222

## Description

The invention relates generally to utility meters, and more specifically to systems and methods for storing energy usage based on ambient temperature associated with the energy utility meters. Energy infrastructure, such as a smart grid infrastructure, may include a variety of systems and components with sensors and memory devices to detect and store data. In the smart grid example, systems may include power generation systems, power transmission systems, smart meters, digital communications systems, control systems, and their related components. Certain smart meters may include various sensor and memory systems to detect and store energy usage data according to certain energy rates associated with the energy usage. It may be useful to improve methods to detect and store energy usage data.

Document US 2010/0153035 A1 discloses a method, via a processor, of forecasting energy usage using historical temperature and humidity data. The scope of the present invention is defined by the appended claims. Certain embodiments are summarized below. These embodiments are not intended to limit the scope of the claimed invention, but rather these embodiments are intended only to provide a brief summary of possible forms of the invention. Indeed, the invention may encompass a variety of forms that may be similar to or different from the embodiments set forth below.

A system includes a utility meter. The utility meter includes a sensor configured to detect a utility usage, a processor configured to determine an ambient temperature of the utility meter, and a memory configured to store a data collection system. The data collection system is configured to be utilized by the processor to store the utility usage at least partially according to the ambient temperature of the utility meter.

A non-transitory computer-readable medium having code stored thereon, the code includes instructions to determine a utility usage via a utility meter, receive an indication of an ambient temperature associated with the utility meter during a period of time corresponding to the utility usage, and store the utility usage at least partially according to the ambient temperature.

A system includes a utility meter. The utility meter includes a first sensor configured to detect a utility usage, a second sensor configured to detect an ambient temperature of the utility meter, and a processor configured to execute a program stored in a memory of the utility meter. The program includes a data collection system configured to store the utility usage at least partially according to the ambient temperature of the utility meter.

These and other features, aspects, and advantages of the present invention will become better understood when the following detailed description is read with reference to the accompanying drawings in which like characters represent like parts throughout the drawings, wherein:
FIG. 1 is a block diagram of an embodiment of a energy generation, transmission, and distribution infrastructure system, in accordance with present embodiments;
FIG. 2 is a block diagram of an embodiment of a metering system included in the system of FIG. 1, in accordance with present embodiments;
FIG. 3 is a block diagram of an embodiment of a data collection system of the metering system of FIG. 2, in accordance with present embodiments; and
FIG. 4 is a flowchart illustrating an embodiment of a process for calculating and storing utility usage according to ambient temperature, in accordance with present embodiments.

One or more specific embodiments of the invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the invention, the articles "a," "an," "the," and "said" are intended to mean that there are one or more of the elements. The terms "comprising," "including," and "having" are intended to be inclusive and mean that there may be additional elements other than the listed elements.

Present embodiments relate to a utility meter that may calculate and store utility usage data according to the time-of-use (TOU) rates specified by the utility and the ambient temperature associated with the time of the utility usage. The utility meter may include a data collection system to store the utility usage data to correspond to certain utility rates based on, for example, the time of day (e.g., off-peak, near-peak, and peak hours), the day of the week (e.g. weekday, weekend, holiday), season of the year, and so forth. The data collection system of the utility meter may also, in addition to, or irrespective of the TOU, store the utility usage data according to certain utility rates based on, for example, the ambient temperature during the time of the utility usage. In one embodiment, the utility meter may include one or more sensors to determine ambient temperature as well as one or more sensors that may monitor utility usage (e.g., electricity, gas, water, etc. usage). In another embodiment, the utility meter may receive ambient temperature data relating to a particular consumer or relating to a cluster of consumers via one or more communications interfaces.

As used herein, "ambient temperature" may refer to the temperature inside a system enclosure, or the temperature of a surrounding area of the system enclosure. Similarly, "ambient temperature" may refer to the temperature of a system irrespective of any temperature increase or decrease due to the operation of the system itself. That is, the ambient temperature may be the temperature surrounding the system that may be unaffected by temperature change (e.g., heat radiation) associated with the operation of the system. Yet still, "ambient temperature" may refer to the temperature of the air inside or outside of the system when the system is operative. For example, the temperature of the air inside of the system may be reflective of the temperature of the air outside of the system, or may be proportional to the temperature of the air outside of the system. Similarly, as used herein "utility" may refer to a service such as electricity, gas, or water that may provided to a consumer by a public utility provider (e.g., electricity utility provider, gas utility provider, water utility provider, and so forth) for use by the consumer. Moreover, the techniques described herein may not be limited to electricity meters, but may also be extended to any utility meter such as gas meters, water meters, aeration meters, and the like. It should also be appreciated that the embodiments described herein may be retrofitted to existing utility meters without adding (or removing) hardware components.

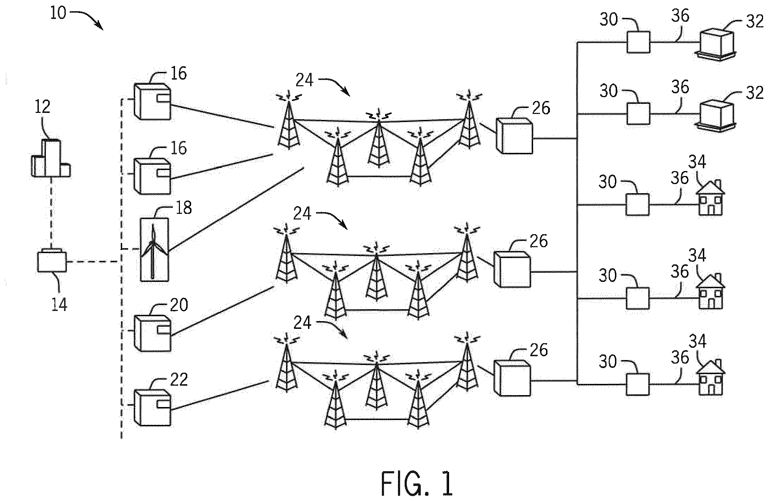

With the foregoing in mind, it may be useful to describe an embodiment of an infrastructure, such as an example energy grid system 10 illustrated in FIG. 1. It is to be noted that the systems and methods described herein may apply to a variety of infrastructure, including but not limited to power distribution infrastructure, gas delivery infrastructure, and various fluid (e.g., water) delivery infrastructure. As depicted, the energy grid system 10 may include one or more utility provider 12. The utility provider 12 may provide for oversight operations of the energy grid system 10. For example, utility control centers 14 may monitor and direct power produced by one or more power generation stations 16 and alternative utility generation stations 18, 20, and 22. The power generation stations 16 may include conventional power generation stations, such as power generation stations using gas, coal, biomass, and other carbonaceous products for fuel. The alternative utility generation station 18 may include power generation stations using solar power, wind power, hydroelectric power, geothermal power, and other alternative sources of power (e.g., renewable energy) to produce electricity. Other alternative utility generation stations may include a water power producing plant 20 and geothermal power producing plant 22. For example, water power producing plants 20 may provide for hydroelectric power generation, and geothermal power producing plants 22 may provide for geothermal power generation.

The power generated by the power generation stations 16, 18, 20, and 22 may be transmitted through a power transmission grid 24. The power transmission grid 24 may cover a broad geographic region or regions, such as one or more municipalities, states, or countries. The transmission grid 24 may also be a single phase alternating current (AC) system, but most generally may be a three-phase AC current system. As depicted, the power transmission grid 24 may include a series of towers to support a series of overhead electrical conductors in various configurations. For example, extreme high voltage (EHV) conductors may be arranged in a three conductor bundle, having a conductor for each of three phases. The power transmission grid 24 may support nominal system voltages in the ranges of 110 kilovolts (kV) to 765 kilovolts (kV) or more. In the depicted embodiment, the power transmission grid 24 may be electrically coupled to a power distribution substation and grid 26. The power distribution substation and grid 26 may include transformers to transform the voltage of the incoming power from a transmission voltage (e.g., 765 kV, 500kV, 345kV, or 138kV) to primary (e.g., 13.8kV or 4160V) and secondary (e.g., 480V, 240V, or 120V) distribution voltages. For example, industrial electric power consumers (e.g., production plants) may use a primary distribution voltage of 13.8kV, while power delivered to commercial and residential consumers may be in the secondary distribution voltage range of 120V to 480V.

As again depicted in FIG. 1, the power transmission grid 24 and power distribution substation and grid 26 may be part of the energy grid system 10. Accordingly, the power transmission grid 24 and power distribution substation 26 may include various digital and automated technologies to control power electronic equipment such as generators, switches, circuit breakers, reclosers, and so forth. The power transmission grid 24 and power distribution substation and grid 26 may also include various communications, monitoring, and recording devices such as, for example, programmable logic controllers (PLCs) and electric fault sensing protective relays. In certain embodiments, the power transmission grid 24 and power distribution substation and grid 26 may also deliver power and communicate data such as changes in electric load demand to a meter 30.

In certain embodiments, the meter 30 may be an Advanced Metering Infrastructure (AMI) meter used to collect, measure, and analyze electric power usage and/or generation. The meter 30 may be electrically and communicatively coupled to one or more of the components of the system 10, including the power transmission grids 24, power distribution substation and grid 26, and the commercial and/or industrial consumer 32 and residential consumer 34. Additionally, the meter 30 may enable two-way communication between commercial sites 32, residences 34, and the utility control center 14, providing for a link between consumer behavior and electric power usage and/or generation. For example, the meter 30 may track and account for prepaid energy usage and/or energy used before payment. As will be further appreciated, the utility's consumers (e.g., commercial sites 32, residences 34) may benefit from lower utility charges by optimizing their energy consumption, for example, to take advantage of lower rates during low demand hours. As noted above, electric power may also be generated by the consumers (e.g., commercial consumers 32, residential consumers 34). For example, the consumers 32, 34 may interconnect a distributed generation (DG) resource (e.g., solar panels or wind turbines) to generate and deliver power to the grid 26.

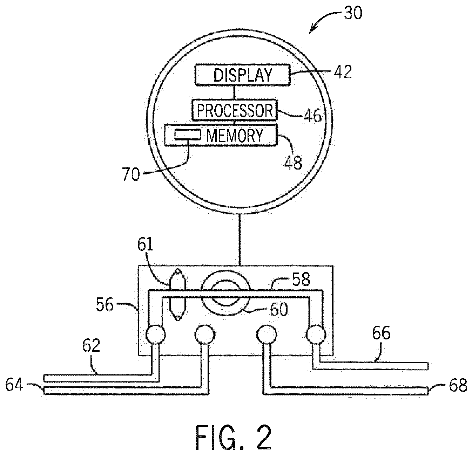

In certain embodiments, as depicted in FIG. 2, the meter 30 may include a system of electrical and electronic components such as, for example, a display 42, one or more processors 46, one or more memory devices 48, a housing 56, one or more bus bars 58, and sensors 60 and 61. It should be appreciated the meter 30 as depicted in FIG. 2 may represent an example embodiment of the meter 30. Particularly, the meter 30 may include any of a number of embodiments of an energy meter. For example, other embodiments may include a 3-wire (e.g., two energized conductors and one neutral) typical for residential consumers (e.g., residential consumers 34), or a 3-phase 4-wire (e.g., three energized conductors and one neutral) meter typical for industrial or commercial consumers (e.g., commercial consumers 32). In one embodiment, the sensor 60 may be a current sensor (e.g., current transformer (CT), Hall Effect Sensor, shunt resistor, or Rogowski coil)) useful in detecting current flowing through the one or more bus bars 58 and/or source-side and load-side live and neutral conductors 62, 64, 66, and 68. Similarly, the sensor 61 may be a temperature sensor (e.g., thermocouples, resistance temperature detectors (RTDs), thermometers, and the like) that may be included as part of the meter 30 (e.g., included within, or external to the housing 56) to measure the ambient temperature (e.g., the temperature inside, outside, surrounding, or nearby the meter 30) associated with the meter 30.

The processor 46 and/or other data processing may be communicatively coupled to the memory 48 to execute instructions for carrying out the presently disclosed techniques. These instructions may be encoded in code stored in tangible non-transitory computer-readable medium, such as the memory 48 and/or other storage. The processor 46 may be a general-purpose processor, system-on-chip (SoC) device, or some other processor configuration. It should also be appreciated that the meter 30 may measure, calculate, store, and display an apparent power (kVA), real power (i.e., the average power consumed by the resistive component of a given load 32, 34 over a time interval) (kW), and reactive power (i.e., the power consumed by the reactive component of a given load 32,34 over a time interval) (kvar) as a product of power and time. For example, electric utility providers (e.g., utility provider 12) may report to consumers their usage and/or generation per kilowatt-hour (kWh) for billing and/or crediting purposes.

According to the invention, the meter 30 also includes a data collection system 70. Indeed, the data collection system 70 may be a program or any software system stored in the memory 48 of the meter 30, and utilized, for example, by the processor 46 to carry out the presently disclosed techniques. The data collection system 70 may be suitable for analyzing and/or modeling energy delivery data and/or business data (e.g., energy billing rates) related to the meter 30 and/or the consumers 32, 34. For example, as will be discussed in further detail below, the data collection system 70 may include various subsystems (e.g., software systems implemented as computer executable instructions stored in a non-transitory machine readable medium) that may be used to derive and store data related to certain business parameters such as billed and unbilled energy, billing cycle data, energy rates, and so forth. Accordingly, the data collection system 70 may receive continuous updates of the energy usage of the consumers 32 and 34, and report such information to the utility provider 12 and/or utility control center 14. Indeed, the data collection system 70 may store the cost of energy, the amount of energy used at the use end point (e.g., commercial buildings, residences) and/or billed to the consumers 32, 34, the amount of energy unbilled (e.g., energy used by the consumers 32, 34 or lost over a billing cycle but has not yet been billed), time-of-use (TOU) data, usage and load profiles, and so forth.

For example, in certain embodiments, the data collection system 70 may receive and/or analyze data received via an interface with an Outage Management System (OMS), a Distribution Management System (DMS), a Geographic Information System (GIS), a Customer Information System (CIS), a Meter Data Management (MDM) system, and AMI or Automatic Meter Reading (AMR) network systems. Thus, the data collection system 70 of the meter 30 may access, store, and/or manage large quantities of customer energy data (e.g., consumers 32, 34), including billing information, energy usage information, billing rates, load profiles, and the like. In certain embodiments, the data collection system 70 may also interface with a Meter Data Repository (MDR), which may store the amount of electricity used, for example, during peak, near-peak, and off-peak hours. The data collection system 70 may also include data received from external data services such as weather prediction systems (e.g., Global Forecast System, Doppler radars, and so forth), as the weather may affect the transmission and delivery of energy via the grids 24 and 26 to the meter 30 associated with consumers 32, 34.

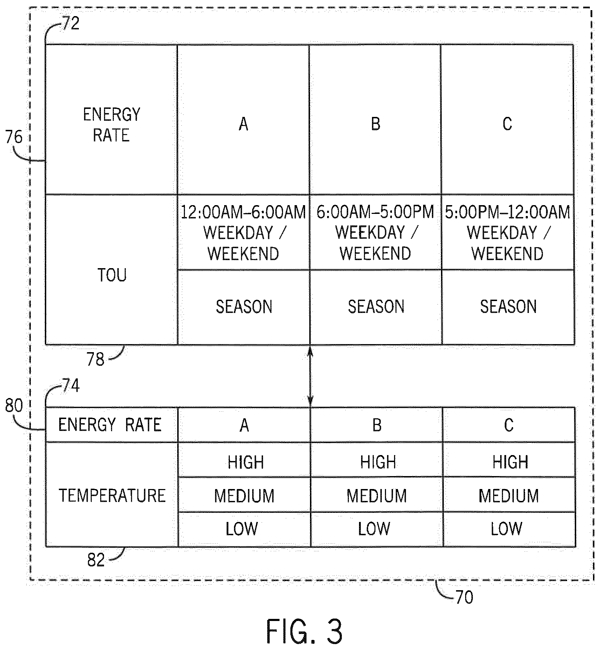

In certain embodiments, the data collection system 70 may also include systems to calculate and/or estimate utility billing rates based on ambient temperature data, in addition to TOU data detected and/or received by the meter 30. For example, as illustrated in FIG. 3, the data collection system 70 may include a TOU data repository 72 and a temperature data repository 74. The data repositories 72 and 74 may each include a number of data buckets (e.g., package containments of data) that may store consumer (e.g., consumers 32, 34) usage and/or generation data received via the meter 30. Specifically, the data collection system 70 of the meter 30 may be configured to receive an indication of energy usage and record energy usage according to one or more time-based, temperature-based, or similar parameter-based mechanisms. As depicted, TOU data repository 72 may include energy rate slots 76 (e.g., "A," "B," 'C"), which may also be referred to as energy tariff slots. The energy rate slots 76 may each represent different energy rates (e.g., "A"-lowest/off-peak rate, "B"-average/near-peak rate, "C"-highest/on-peak rate) depending on, for example, TOU timeslots 78. For example, the energy rate slots 76 (e.g., "A," "B," 'C") may each represent a data bucket for the storage of consumer 32, 34 energy usage data and the mapping to the corresponding energy rate. Specifically, as the meter 30 measures the consumers' 32, 34 energy usage (e.g., kWh) over, for example, an approximately 1, 2, 5, 10, 15, 30, 45, 60, 120, 240 minute duration of time, the meter 30 may store the usage data to one or more data buckets according to the energy rate slot 76 and corresponding TOU timeslot 78. As further illustrated, the TOU timeslots 78 may include a categorization of consumer 32, 34 energy usage over, for example, various ranges of hours of a single day.

For example, the TOU timeslot 76 corresponding to the off-peak energy rate slot 76 (e.g., off-peak energy rate "A") may include, for example, a block of hours ranging from 12:00 a.m. to 6:00 a.m. Thus, the data collection system 70 of the meter 30 may timestamp and store consumer 32, 34 energy usage detected during these times according to the off-peak rate (e.g., energy rate slot A). Similarly, the TOU timeslot 76 corresponding to the near-peak energy rate slot 76 (e.g., off-peak energy rate B) may include, for example, a block of hours ranging from 6:00 a.m. to 5:00 p.m., while the TOU timeslot 76 corresponding to the peak energy rate slot 76 (e.g., off-peak energy rate C) may include, for example, a block of hours ranging from 5:00 p.m. to 12:00 a.m. Accordingly, the data collection system 70 of the meter 30 may timestamp and store consumer 32, 34 energy usage detected during times of the day (e.g., 6:00 a.m. to 5:00 p.m.) according to the near-peak rate (e.g., energy rate slot B), and during the times of the day 5:00 p.m. to 12:00 a.m. according to the on-peak rate (e.g., energy rate slot C). As further illustrated, the data collection system 70 of the meter 30 may also apply energy rates according to the season of the year such as, for example, where each of the energy rates (e.g., A-lowest/off-peak rate, B-average/shoulder rate, C-highest/on-peak rate) of the energy rate slots 76 may be higher (e.g., due to consumer 32, 34 rising energy demand for cooling systems, and the increase in cost of electric power generation) during the latter spring and summer months (e.g., May-September), but much less during the cooler winter months (e.g., October-April). Thus, the data collection system 70 may include data that may be continuously adjusted as energy usage and/or generation may vary from one billing cycle to another (or from one part of the day to another) due to weather variation, the date and time that the meter 30 is read, seasonal changes, holidays and weekends, and so forth.

In certain embodiments, the data collection system 70 of the meter 30 may also store detected consumer 32, 34 energy usage data according to the ambient temperature of the meter 30. As previously noted, the meter 30 may include one or sensors (e.g., sensors 60 and 61) to detect the ambient temperature of the meter 30. In other embodiments, the meter 30 may receive ambient temperature via one or more of the OMS, DMS, GIS, CIS, MDM, MDR, and AMI network interfaces that may be included as part of the meter 30. For example, the utility provider 12 and/or utility control center 14 may transmit ambient temperature of a cluster of meters 30 of certain geographical areas (e.g., counties, regions, cities, communities, and neighborhoods). In other embodiments, the utility provider 12 and/or utility control center 14 may transmit the specific ambient temperature data for each meter 30 associated with each consumer 32, 34. For example, the utility provider 12 and/or utility control center 14 may transmit via an AMI network the ambient temperature data for each meter over, for example, approximately 1, 2, 5, 10, 15, 30, 45, 60, 120, or 240 minute time intervals to coincide with the intervals in which the energy usage of the meters 30 may be read by the utility provider 12 and/or utility control center 14. Yet still, in other embodiments, each of the meters 30 may use data received via communication with one or more nearby weather prediction systems (e.g., Global Forecast System, Doppler radars, and so forth). Specifically, by determining the ambient temperature for each meter 30, the energy usage of the consumers 32, 34 may be subject to lower billing rates when, for example, a residential consumer 34 and corresponding meter 30 may be positioned in a place of lower ambient temperature as compared with the energy usage of other residential consumers 34 within the same neighborhood, community, and/or region.

For example, as previously noted, the data collection system 70 may also include a temperature data repository 74 to store energy usage data based on the ambient temperature of the meter 30. It should be appreciated that the data collection system 70 may include the temperature data repository 74 and associated consumer 32, 34 meter 30 ambient temperature data as an addition of the TOU data of the TOU data repository 72. That is, the data collection system 70 may calculate and store energy usage based on both TOU data and ambient temperature data. However, in other embodiments, the data collection system 70 of the meter 30 may store consumer 32, 34 energy usage data and corresponding energy rates based solely upon the ambient temperature data (e.g., instead of an aggregate of TOU data and ambient temperature data). As illustrated in FIG. 3, the temperature data repository 74 may include energy rate slots 80 (e.g., "A," "B," 'C"). In certain embodiments, energy rate slots 80 (e.g., "A," "B," 'C") may include substantially the same energy rates (e.g., energy rates in terms of currency per kWh) of the energy rate slots 76 (e.g., "A," "B," 'C") of the TOU data repository 72. In this way, the TOU data may be aggregated with the ambient temperature data, and the utility provider (e.g., utility provider 12) may determine the appropriate energy rate for the consumers' 32, 34 energy usage. In another embodiment, the energy rate slots 80 (e.g., "A," "B," 'C") may not include specific energy rates (e.g., kWh), but may each correspond to certain tariffs, surcharges, and/or possible discounts that may be applied according to the ambient temperature data of the meter 30.

As further illustrated, the temperature data repository 74 may include ambient temperature slots 82. The ambient temperature slots 82 may include, for example, a number of predetermined (e.g., configured during manufacturing of the meter 30) and/or utility-configured (e.g., configured by the utility provider 12, or other energy service provider) temperature ranges such as a "High" (e.g., 90-110 deg.), "Medium" (e.g., 50-80 deg.), and "Low" (e.g., 0-40 deg.) temperature range. However, it should be appreciated that the depicted temperature ranges (e.g., "High," "Medium," and "Low") of the ambient temperature slots 82 are included merely for the purpose of illustration. In certain embodiments, the temperature slots 82 may include any number of temperature ranges and/or designations such as, for example, specific temperature ranges and/or designations accounting for variations in air quality, humidity, seasons, climate (e.g., regionally, nationally), and so forth. Furthermore, the meter 30 may be configured to adjust the temperature ranges (e.g., "High," "Medium," and "Low") according to the historical and/or typical ambient temperature range for certain geographical areas (e.g., county, region, city, community, or neighborhood). In such a case, the meter 30 may register a "High" temperature as approximately 1 degree above a typical "Medium" temperature, and register a "Low" temperature as approximately 1 degree below the typical "Medium" temperature. In other words, in certain embodiments, the temperature ranges (e.g., "High," "Medium," and "Low") may be relative to, or based on a comparison of a cluster of meters 30 associated consumers 32, 34 of a particular geographical area.

Thus, the data collection system 70 of the meter 30 may not only calculate and store energy usage according to the TOU (e.g., according to whether energy usage detected during off-peak, near-peak, or peak periods), but may also calculate and store the energy usage according to the ambient temperature of the meter 30 associated with the consumers 32, 32. For example, as previously discussed, the meter 30 may register consumer 32, 34 energy usage during a peak period (e.g., during hours of the day ranging from 5:00 p.m. to 12:00 a.m.) and store the energy usage to correspond to an energy rate of "C." In the same instance, the meter 30 may determine the ambient temperature of the meter 30, and determine whether the ambient temperature is one of a "High," "Medium," or "Low" temperature. Depending on the ambient temperature, the data collection system 70 may store the ambient temperature along with the energy usage, in which the ambient temperature may indicate certain tariffs, surcharges, and/or possible discounts to be applied with, for example, the energy rate "C." In another embodiment, the data collection system of the meter 30 may determine the energy rates (e.g., energy rates "A," "B," and "C") based solely upon the ambient temperature data of the meter 30. That is, the consumer 32, 34 may possibly be billed at a lower energy rate (e.g., rate "A") as opposed to higher energy rate (e.g., rate "C"), or vice-versa, depending on the ambient temperature during the time (e.g., month, week, day, hour) of the consumers' 32, 34 energy usage.

In certain embodiments, the meter 30 may calculate and store the TOU data of the TOU data repository 72 and the ambient temperature data of temperature data repository 74, and transmit the TOU data together with the ambient temperature data to, for example, the utility provider 12 and/or utility control center 14. For example, the meter 30 may transmit ambient temperature data during each interval (e.g., 1, 2, 5, 10, 15, 30, 45, 60, 120, 240 minute intervals) the meter 30 transmits energy usage data to the utility provider 12 and/or utility control center 14. In this way, the meter 30 may account for changes in the ambient temperature as the day passes, or in such cases that the consumer 32, 34 include facility shadings (e.g., vegetation, shade roofs, and so forth) that may affect the ambient temperature of the meter 30, and by extension, the energy rate of the consumer 32, 34. In another embodiment, the meter 30 may store the ambient temperature data (e.g., raw data) along with the load profile data to be analyzed once the load profile data is transmitted to, for example, the utility provider 12 and/or utility control center 14.

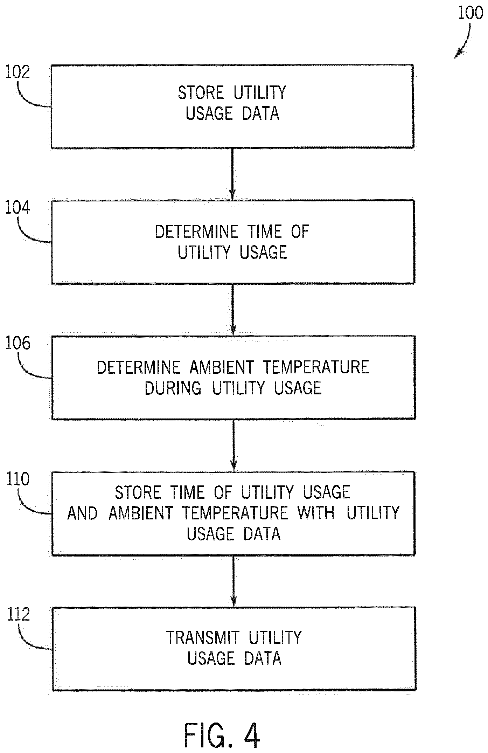

Turning now to FIG. 4, a flow diagram is presented, illustrating an embodiment of a process 100 suitable for calculating and storing utility usage according to time-of-use (TOU) and ambient temperature by using, for example, the data collection system 70 stored in the memory 48 and utilized by the processor 46 of the meter 30 depicted in FIG. 2. Thus, the process 100 may include code or instructions stored in a non-transitory machine-readable medium (e.g., the memory 48) and executed, for example, by one or more processors 48 included in the meter 30. The process 100 may begin with the data collection system 70 of the meter 30 storing (block 102) utility usage data. For example, as previously discussed, the data collection system 70 of the meter 30 store utility usage detected via one or more sensors (e.g., sensors 60 and 61) of the meter 30, and generate a load profile over various time intervals (e.g., 1, 2, 5, 10, 15, 30, or more minute intervals) reflecting the utility usage of, for example, the consumers 32, 34. The process 100 may continue with the data collection system 70 of the meter 30 determining (block 104) the time-of-use (TOU) of the utility usage data. For example, the data collection system 70 of the meter 30 may determine and store the date (e.g., day of the week, month of the year) and time (e.g., hour of the day) associated with the utility usage data.

The process 100 may then continue with the data collection system 70 of the meter 30 determining (block 106) the ambient temperature during the time the utility usage data is detected. For example, the data collection system 70 of the meter 30 may receive ambient temperature data of the meter 30 via the sensors 60 and 61, or via an interface with one or more of OMS, DMS, GIS, CIS, MDM, MDR, and/or AMI network and/or repository systems. The data collection system 70 of the meter 30 may then store (block 110) the TOU of the utility usage data and the ambient temperature during the time the utility usage data is detected along with the utility usage data (e.g., consumer 32, 34 load profile data). For example, the data collection system 70 of the meter 30 may store the utility usage data in one or more data buckets corresponding to a tier of utility rates according to the TOU data and ambient temperature data. That is, as previously noted, the data collection system 70 of the meter 30 may store the utility usage data according to whether the utility usage is detected on a certain day of the week (e.g., weekday, weekend, holiday), time of the day (e.g., off-peak, near-peak, and peak hours), season of the year, and so forth. The data collection system 70 of the meter 30 may further store the utility usage data according to the ambient temperature (e.g., based on whether the ambient temperature is high, medium, low, and so forth) during the time (e.g., hour, day, week, month) the utility usage data is detected. Yet still, as also noted above, in certain embodiments, the data collection system 70 of the meter 30 may store the utility usage data based solely upon the ambient temperature data of the meter 30. The process 100 may conclude with the meter 30 transmitting (block 112) the utility usage data (e.g., utility usage data of the consumer 32, 34) along with the TOU data and ambient temperature data to, for example, the utility provider 12 and/or utility control center 14 for informational, billing, and/or crediting purposes.

Technical effects of the disclosed embodiments relate to a utility meter that may calculate and store utility usage data according to the time-of-use (TOU) of the utility and the ambient temperature associated with the time of the utility usage. The utility meter may include a data collection system to store the utility usage data to correspond to certain utility rates based on, for example, the time of day (e.g., off-peak, near-peak, and peak hours), the day of the week (e.g. weekday, weekend, holiday), season of the year, and so forth. The data collection system of the utility meter may also, in addition to, or irrespective of the TOU, store the utility usage data to correspond to certain utility rates based on, for example, the ambient temperature during the time of the utility usage. In one embodiment, the utility meter may include one or more sensors to determine ambient temperature as well as one or more sensors that may monitor utility usage (e.g., electricity, gas, water, etc. usage). In another embodiment, the utility meter may receive ambient temperature data relating to a particular consumer or relating to a cluster of consumers via one or more communications interfaces.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims.

## Claims

1. A system comprising:
a utility meter (30), comprising
a sensor (60, 61) configured to detect a utility usage;
a processor (46) configured to determine an ambient temperature of the utility meter (30); and
a memory (48) configured to store a data collection system (70), wherein the processor (46) is configured to utilize the data collection system (70) to store the utility usage at least partially according to the ambient temperature of the utility meter (30).

2. The system of claim 1, comprising a second sensor (60, 61), wherein the second sensor comprises a temperature sensor configured to detect the ambient temperature of the utility meter (30).

3. The system of claim 1 or claim 2, wherein the processor (46), utilizing the data collection system (70), is configured to store the utility usage at least partially according to a time-of-use (TOU) of the utility usage, wherein, preferably, the processor (46) is configured to timestamp a value indicative of the utility usage to determine the time-of-use (TOU), and wherein the TOU comprises a time of the day, a day of the week, a month of the year, a season of the year, or any combination thereof.

4. The system of claim 1, 2 or 3, wherein the processor (46), utilizing the data collection system (70), is configured to store the utility usage in one of a plurality of time-of-use (TOU) rates, wherein the plurality of TOU rates comprises an off-peak rate, a peak rate, or a combination thereof, wherein, preferably, the data collection system is configured to store a plurality of ranges of ambient temperature values, and wherein each of the plurality of ranges of ambient temperature values corresponds to at least one of the off-peak rate and the peak rate.

5. The system of claim 1, wherein the processor (46), utilizing the data collection system (70), is configured to store the utility usage based on an aggregate of the ambient temperature of the utility meter (30) and a time-of-use (TOU) of the utility usage.

6. The system of any preceding claim, wherein the processor (46) is configured to match the ambient temperature with a configurable range of ambient temperature values, and wherein the data collection system (70) is configured to store the utility usage according to whether the configurable range of ambient temperature values is one of a high range of ambient temperature values, a medium range of ambient temperature values, or a low range of ambient temperature values.

7. The system of any preceding claim, wherein the utility meter (30) is configured to transmit an indication of the utility usage, an indication of the ambient temperature of the utility meter (30), or a combination thereof.

8. The system of any preceding claim, wherein the processor (46) is configured to determine the ambient temperature of the utility meter (30) by receiving an indication from an Advanced Metering Infrastructure (AMI), an Outage Management System (OMS), a Distribution Management System (DMS), a Geographic Information System (GIS), a Customer Information System (CIS), a Meter Data Management System (MDM), a Meter Data Repository (MDR), or any combination thereof.

9. A system according to any of the preceding claims in combination with claim 2, wherein the processor (46) is configured to execute a program stored in the memory (48) of the utility meter (30), wherein the program comprises the data collection system (70) configured to store the utility usage at least partially according to the ambient temperature of the utility meter (30).

10. The system of claim 9, wherein the first sensor (60) comprises a current sensor configured to detect an electric power usage, and wherein the second sensor comprises a temperature sensor disposed inside an enclosure of the utility meter (30).

11. The system of claim 9 or claim 10, wherein the utility meter (30) is configured to store the utility usage at least once for each of a plurality of time intervals, and wherein the data collection system (70) is configured to store a value of the ambient temperature along with the utility usage at least once for each of the plurality of time intervals.

12. The system of claim 9, 10 or 11, wherein the data collection system (70) is configured to store the utility usage according to a time-of-use (TOU) of the utility usage and whether the ambient temperature of the utility meter (30) corresponds to one of a stored plurality of ranges of ambient temperature values.

13. The system of claim 9, 10, 11 or 12, wherein the utility usage comprises an electric power usage, and wherein the utility meter (30) is configured to transmit an indication of the electric power usage, an indication of the ambient temperature of the utility meter (30), or a combination thereof.

14. A non-transitory computer-readable medium having computer executable code stored thereon, the code comprising instructions to:
determine a utility usage via a utility meter (30);
receive an indication of an ambient temperature associated with the utility meter (30) during a period of time corresponding to the utility usage; and
store the utility usage at least partially according to the ambient temperature.

15. The non-transitory computer-readable medium of claim 14, wherein at least one of:
the code comprises instructions to store the utility usage to correspond to one of a plurality of stored rates, wherein the plurality of stored rates comprises an offpeak rate, a peak rate, or a combination thereof, wherein, preferably, the code comprises instructions to store a plurality of ranges of ambient temperature values, and wherein each of the plurality of ranges of ambient temperature values corresponds to at least one of the off-peak rate and the peak rate;
the code comprises instructions to store the utility usage based on an aggregate of the ambient temperature associated with the utility meter (30) and a time-of-use (TOU) of the utility usage, and
the code comprises instructions to transmit an indication of the utility usage, the indication of the ambient temperature, or a combination thereof.

## Patentansprüche

1. System, umfassend:
einen Verbrauchszähler (30), umfassend
einen Sensor (60, 61), der dafür ausgelegt ist, einen Versorgungsverbrauch zu erfassen;
einen Prozessor (46), der dafür ausgelegt ist, eine Umgebungstemperatur des Verbrauchszählers (30) zu ermitteln; und einen Speicher (48), der dafür ausgelegt ist, ein Datenerfassungssystem (70) zu speichern, wobei der Prozessor (46) dafür ausgelegt ist, das Datenerfassungssystem (70) zur Speicherung des Versorgungsverbrauchs mindestens teilweise gemäß der Umgebungstemperatur des Verbrauchszählers (30) zu nutzen.

2. System nach Anspruch 1, umfassend einen zweiten Sensor (60, 61), wobei der zweite Sensor einen Temperatursensor umfasst, der dafür ausgelegt ist, die Umgebungstemperatur des Verbrauchszählers (30) zu detektieren.

3. System nach Anspruch 1 oder Anspruch 2, wobei der das Datenerfassungssystem (70) nutzende Prozessor (46) dafür ausgelegt ist, den Versorgungsverbrauch mindestens teilweise gemäß einem Nutzungszeitpunkt (Time of use, TOU) des Versorgungsverbrauchs zu speichern, wobei, bevorzugt, der Prozessor (46) dafür ausgelegt ist, einen Wert, der den Versorgungsverbrauch anzeigt, mit einem Zeitstempel zu versehen, um den Nutzungszeitpunkt (TOU) zu ermitteln, und wobei der TOU eine Tageszeit, einen Wochentag, einen Monat des Jahres, eine Jahreszeit oder gleich welche Kombination davon umfasst.

4. System nach Anspruch 1, 2 oder 3, wobei der das Datenerfassungssystem (70) nutzende Prozessor (46) dafür ausgelegt ist, den Versorgungsverbrauch in einem von einer Vielzahl von Nutzungszeitpunkt-(TOU)-Tarifen zu speichern, wobei die Vielzahl von TOU-Tarifen einen Niedertarif, einen Hochtarif oder eine Kombination davon umfasst, wobei, bevorzugt, das Datenerfassungssystem dafür ausgelegt ist, eine Vielzahl von Bereichen von Umgebungstemperaturwerten zu speichern, und wobei jeder der Bereiche von Umgebungstemperaturwerten mindestens einem des Niedertarifs und des Hochtarifs entspricht.

5. System nach Anspruch 1, wobei der das Datenerfassungssystem (70) nutzende Prozessor (46) dafür ausgelegt ist, den Versorgungsverbrauch auf Basis eines Aggregats der Umgebungstemperatur des Verbrauchszählers (30) und eines Nutzungszeitpunkts (TOU) des Versorgungsverbrauchs zu speichern.

6. System nach gleich welchem vorhergehenden Anspruch, wobei der Prozessor (46) dafür ausgelegt ist, die Umgebungstemperatur mit einem konfigurierbaren Bereich von Umgebungstemperaturwerten abzugleichen, und wobei das Datenerfassungssystem (70) dafür ausgelegt ist, den Versorgungsverbrauch je nachdem zu speichern, ob der konfigurierbare Bereich von Umgebungstemperaturwerten einer von einem hohen Bereich von Umgebungstemperaturwerten, einem mittleren Bereich von Umgebungstemperaturwerten oder einem niedrigen Bereich von Umgebungstemperaturwerten ist.

7. System nach gleich welchem vorhergehenden Anspruch, wobei der Verbrauchszähler (30) dafür ausgelegt ist, eine Anzeige des Versorgungsverbrauchs, eine Anzeige der Umgebungstemperatur des Verbrauchszählers (30) oder eine Kombination davon zu übertragen.

8. System nach gleich welchem vorhergehenden Anspruch, wobei der Prozessor (46) dafür ausgelegt ist, die Umgebungstemperatur des Verbrauchszählers (30) durch Empfangen einer Anzeige von einer "fortschrittlichen Mess-Infrastruktur" (Advanced Metering Infrastructure, AMI), einem Ausfallanalysesystem (Outage Management System, OMS), einem Vertriebsverwaltungssystem (Distribution Management System, DMS), einem geografischen Informationssystem (Geographie Information System, GIS), einem Kundeninformationssystem (Customer Information System, CIS), einem Zählerdatenverwaltungssystem (Meter Data Management System, MDM), einem Zählerdatenspeicher (Meter Data Repository, MDR) oder gleich welcher Kombination davon zu ermitteln.

9. System nach gleich welchem der vorhergehenden Ansprüche in Kombination mit Anspruch 2, wobei der Prozessor (46) dafür ausgelegt ist, ein in dem Speicher (48) des Verbrauchszählers (30) gespeichertes Programm auszuführen, wobei das Programm das Datenerfassungssystem (70) umfasst, das dafür ausgelegt ist, den Versorgungsverbrauch mindestens teilweise gemäß der Umgebungstemperatur des Verbrauchszählers (30) zu speichern.

10. System nach Anspruch 9, wobei der erste Sensor (60) einen Stromsensor umfasst, der dafür ausgelegt ist, einen Stromverbrauch zu erfassen, und wobei der zweite Sensor einen Temperatursensor umfasst, der im Inneren einer Umhüllung des Verbrauchszählers (30) angeordnet ist.

11. System nach Anspruch 9 oder Anspruch 10, wobei der Verbrauchszähler (30) dafür ausgelegt ist, den Versorgungsverbrauch mindestens einmal für jedes einer Vielzahl von Zeitintervallen zu speichern, und wobei das Datenerfassungssystem (70) dafür ausgelegt ist, einen Wert der Umgebungstemperatur zusammen mit dem Versorgungsverbrauch mindestens einmal für jedes der Vielzahl von Zeitintervallen zu speichern.

12. System nach Anspruch 9, 10 oder 11, wobei das Datenerfassungssystem (70) dafür ausgelegt ist, den Versorgungsverbrauch gemäß einem Nutzungszeitpunkt (TOU) des Versorgungsverbrauchs und je nachdem, ob die Umgebungstemperatur des Verbrauchszählers (30) einem einer gespeicherten Vielzahl von Bereichen von Umgebungstemperaturwerten entspricht, zu speichern.

13. System nach Anspruch 9, 10, 11 oder 12, wobei der Versorgungsverbrauch einen Stromverbrauch umfasst, und wobei der Verbrauchszähler (30) dafür ausgelegt ist, eine Anzeige des Stromverbrauchs, eine Anzeige der Umgebungstemperatur des Verbrauchszählers (30) oder eine Kombination davon zu übertragen.

14. Nicht-flüchtiges computerlesbares Medium, auf dem computerausführbarer Code gespeichert ist, wobei der Code Instruktionen umfasst, um:
einen Versorgungsverbrauch mittels eines Verbrauchszählers (30) zu ermitteln;
eine Anzeige einer dem Verbrauchszähler (30), während eines dem Versorgungsverbrauch entsprechenden Zeitraums, zugeordneten Umgebungstemperatur zu empfangen; und
den Versorgungsverbrauch mindestens teilweise gemäß der Umgebungstemperatur zu speichern.

15. Nicht-flüchtiges computerlesbares Medium nach Anspruch 14, wobei mindestens eines vorliegt von:
der Code umfasst Instruktionen, um den Versorgungsverbrauch zu speichern, sodass er einer von einer Vielzahl gespeicherter Tarife entspricht, wobei die Vielzahl gespeicherter Tarife einen Niedertarif, einen Hochtarif oder eine Kombination davon umfasst, wobei, bevorzugt, der Code Instruktionen umfasst, um eine Vielzahl von Bereichen von Umgebungstemperaturwerten zu speichern, und wobei jeder der Vielzahl von Bereichen von Umgebungstemperaturwerten mindestens einem des Niedertarifs und des Hochtarifs entspricht;
der Code umfasst Instruktionen, um den Versorgungsverbrauch auf Basis eines Aggregats der dem Verbrauchszähler (30) zugeordneten Umgebungstemperatur und eines Nutzungszeitpunkts (TOU) des Versorgungsverbrauchs zu speichern, und
der Code umfasst Instruktionen, um eine Anzeige des Versorgungsverbrauchs, die Anzeige der Umgebungstemperatur oder eine Kombination davon zu übertragen.

## Revendications

1. Système comprenant :
un compteur (30) comprenant :
un capteur (60, 61) configuré pour détecter une consommation ;
un processeur (46) configuré pour déterminer une température ambiante du compteur (30) ; et
une mémoire (48) configurée pour stocker un système de récolte de données (70) ;
dans lequel le processeur (46) est configuré pour utiliser le système de récolte de données (70) dans le but de mémoriser la consommation au moins en partie en fonction de la température ambiante du compteur (30).

2. Système selon la revendication 1, comprenant un deuxième capteur (60, 61) ; dans lequel le deuxième capteur comprend un capteur de la température configuré pour détecter la température ambiante du compteur (30).

3. Système selon la revendication 1 ou 2, dans lequel le processeur (46), qui utilise le système de récolte de données (70), est configuré pour mémoriser la consommation au moins en partie en fonction d'un temps d'utilisation (TOU) ; dans lequel, de préférence, le processeur (46) est configuré pour horodater une valeur fournissant une indication quant à la consommation afin de déterminer le temps d'utilisation (TOU) ; et dans lequel le TOU comprend un moment dans la journée, une journée dans la semaine, un mois dans l'année, une saison dans l'année ou l'une quelconque de leurs combinaisons.

4. Système selon la revendication 1, 2 ou 3, dans lequel le processeur (46), qui utilise le système de récolte de données (70), est configuré pour mémoriser la consommation dans un tarif choisi parmi plusieurs tarifs de temps d'utilisation (TOU) ; dans lequel lesdits plusieurs tarifs de TOU comprennent : un tarif en heures creuses, un tarif en heures de pointe ou une de leurs combinaisons ; dans lequel, de préférence le système de récolte de données est configuré pour stocker plusieurs plages de valeurs de température ambiante ; et dans lequel chacune desdites plusieurs plages de valeurs de température ambiante correspond à au moins un des tarifs choisis parmi le tarif en heures creuses et le tarif en heures de pointe.

5. Système selon la revendication 1, dans lequel le processeur (46), qui utilise le système de récolte de données (70), est configuré pour mémoriser la consommation en se basant sur un ensemble de la température ambiante du compteur (30) et du temps d'utilisation (TOU).

6. Système selon l'une quelconque des revendications précédentes, dans lequel le processeur (46) est configuré pour une mise en correspondance de la température ambiante avec une plage configurable de valeurs de température ambiante, et dans lequel le système de récolte de données (70) est configuré pour mémoriser la consommation en fonction du fait de savoir si la plage configurable de valeurs de température ambiante représente une plage choisie parmi une plage étendue de valeurs de température ambiante, une plage moyenne de valeurs de température ambiante ou une plage peu étendue de valeurs de température ambiante.

7. Système selon l'une quelconque des revendications précédentes, dans lequel le compteur (30) est configuré pour transmettre une indication quant à la consommation, une indication quant à la température ambiante du compteur (30), ou une de leurs combinaisons.

8. Système selon l'une quelconque des revendications précédentes, dans lequel le processeur (46) est configuré pour déterminer la température ambiante du compteur (30) via la réception d'une indication fournie par une infrastructure de mesure avancée (AMI), un système de gestion des pannes (OMS), un système de gestion de la distribution (DMS), un système d'information à référence spatiale (GIS), un système d'information des clients (CIS), un système de gestion des données de mesure (MDM), un répertoire de données de mesure (MDR), ou l'une quelconque de leurs combinaisons.

9. Système selon l'une quelconque des revendications précédentes en combinaison avec la revendication 2, dans lequel le processeur (46) est configuré pour exécuter un programme mis dans la mémoire (48) du compteur (30) ; dans lequel le programme comprend le système de récolte de données (70) configuré pour mémoriser la consommation au moins en partie en fonction de la température ambiante du compteur (30).

10. Système selon la revendication 9, dans lequel le premier capteur (60) comprend un détecteur de courant configuré pour détecter une consommation d'énergie électrique ; et dans lequel le deuxième capteur comprend un capteur de la température disposé à l'intérieur d'une enceinte du compteur (30).

11. Système selon la revendication 9 ou 10, dans lequel le compteur (30) est configuré pour mémoriser la consommation au moins une fois au cours de chacun desdits plusieurs intervalles de temps ; et dans lequel le système de récolte de données (70) est configuré pour mémoriser une valeur de la température ambiante conjointement avec la consommation au moins une fois au cours de chacun desdits plusieurs intervalles de temps.

12. Système selon la revendication 9, 10 ou 11, dans lequel le système de récolte de données (70) est configuré pour mémoriser la consommation en fonction d'un temps d'utilisation (TOU) et en fonction du fait de savoir si la température ambiante du compteur (30) correspond à une plage choisie parmi plusieurs plages mémorisées de valeurs de température ambiante.

13. Système selon la revendication 9, 10, 11 ou 12, dans lequel la consommation comprend une utilisation d'énergie électrique ; et dans lequel le compteur (30) est configuré pour transmettre une indication quant à l'utilisation d'énergie électrique, une indication quant à la température ambiante du compteur (30), ou une combinaison des deux.

14. Support non temporaire lisible par ordinateur sur lequel est stocké un code exécutable par ordinateur, le code comprenant des instructions pour :
déterminer une consommation via un compteur (30) ;
recevoir une indication concernant une température ambiante associée au compteur (30) au cours d'un laps de temps correspondant à la consommation; et
mémoriser la consommation au moins en partie en fonction de la température ambiante.

15. Support non temporaire lisible par ordinateur, selon la revendication 14, dans lequel au moins une des affirmations suivantes est vraie :
le code comprend des instructions pour mémoriser la consommation afin de correspondre à un desdits plusieurs tarifs mémorisés ; dans lequel lesdits plusieurs tarifs mémorisés comprennent un tarif en heures creuses, un tarif en heures de pointe, ou une de leurs combinaisons ; dans lequel de préférence le code comprend des instructions pour mémoriser plusieurs plages de valeurs de température ambiante ; et dans lequel chacune desdites plusieurs plages de valeurs de température ambiante correspond à au moins un des tarifs choisis parmi le tarif en heures creuses et le tarif en heures de pointe ;
le code comprend des instructions pour mémoriser la consommation en se basant sur un ensemble de la température ambiante associée au compteur (30) et d'un temps d'utilisation (TOU) ; et
le code comprend des instructions pour transmettre une indication quant à la consommation, une indication quant à la température ambiante, ou une de leurs combinaisons.
